(19) Europäisches Patentamt
European Patent Office
Office européen des brevets

(11) EP 4 194 864 A1

(12) DEMANDE DE BREVET EUROPEEN

(43) Date de publication:
**14.06.2023 Bulletin 2023/24**

(21) Numéro de dépôt: **22211347.4**

(22) Date de dépôt: **05.12.2022**

(51) Classification Internationale des Brevets (IPC):
***G01R 31/26*** *(2020.01)* ***G01R 31/27*** *(2006.01)*
***G01R 27/14*** *(2006.01)* ***H01L 29/778*** *(2006.01)*

(52) Classification Coopérative des Brevets (CPC):
**G01R 31/2621; G01R 27/14; G01R 31/275; H01L 29/7786;** H01L 29/1045; H01L 29/2003; H01L 29/41766; H01L 29/4236

(84) Etats contractants désignés:
**AL AT BE BG CH CY CZ DE DK EE ES FI FR GB GR HR HU IE IS IT LI LT LU LV MC ME MK MT NL NO PL PT RO RS SE SI SK SM TR**
Etats d'extension désignés:
**BA**
Etats de validation désignés:
**KH MA MD TN**

(30) Priorité: **07.12.2021 FR 2113071**

(71) Demandeur: **Commissariat à l'énergie atomique et aux énergies alternatives
75015 Paris (FR)**

(72) Inventeurs:
- **ESCOFFIER, René
38054 GRENOBLE Cedex 9 (FR)**
- **MOHAMAD, Blend
38054 GRENOBLE Cedex 09 (FR)**

(74) Mandataire: **Hautier IP
20, rue de la Liberté
06000 Nice (FR)**

# (54) VÉHICULE DE TEST ET MÉTHODE DE TEST POUR DES DISPOSITIFS MICROÉLECTRONIQUES

(57) L'invention porte sur un une structure de test (1) pour un transistor (2) à grille (23) enterrée, comprenant :
- Un premier contact (11) de test situé d'un côté du premier contact (21) de transistor,
- Un deuxième contact (12) de test situé d'un côté du deuxième contact (22) de transistor,
- une couche (30) enterrée dans le substrat (20), présentant un dopage supérieur ou égal à 10^18 cm-3, et présentant une face (301) qui tangente la partie (24) enterrée de la grille (23),
- une première structure d'isolation (41) entre le premier contact (11) de test et le premier contact (21) de transistor,
- une deuxième structure d'isolation (42) entre le deuxième contact (12) de test et le deuxième contact (22) de transistor,

les premier et deuxième contacts (11, 12) de test présentant chacun une extrémité (110, 120) connectant la couche (30) enterrée.

Une méthode de test est également proposée.

1
11
41
21
241
25
23
24
(C)
31
32
22
42
12
$d_{20}$
$e_{30}$
301
120
30
20
110
10
z
x
y
$R_{C1}$
$R_{2DEG1}$
$R_{T1}$
$R_{channel}$
242
240
$R_{T2}$
$R_{C2}$
$R_{2DEG2}$

FIG. 2



Processed by Luminess, 75001 PARIS (FR)

## Description

### DOMAINE TECHNIQUE

La présente invention concerne le domaine de la microélectronique. Elle trouve pour application particulièrement avantageuse la mesure de la résistivité dans des structures de transistors verticaux. Un exemple d'application particulier concerne les transistors de puissance à grille enterrée à gaz bidimensionnel d'électrons (2DEG).

### ETAT DE LA TECHNIQUE

Les structures de transistors de type métal-oxyde-semiconducteur (MOS) verticaux présentent généralement une grille enterrée ou semi-enterrée dont les flancs peuvent participer au chemin de conduction. Les flancs de la grille peuvent être typiquement inclinés ou verticaux.

Différentes architectures de transistors verticaux à base de silicium, de carbure de silicium ou de nitrure de gallium sont divulguées dans les documents « SiC Trench MOSFET With Shielded Fin-Shaped Gate to Reduce Oxide Field and Switching Loss, IEEE Electron Device Letters, Volume: 37, Issue: 10, Oct. 2016 p.1324 - 1327 » et « The trench power MOSFET: Part I - History, technology, and prospects, IEEE Transactions on Electron Devices, Volume: 64, Issue: 3, March 2017 p. 674 - 691 ».

Un enjeu lié à l'étude de tels transistors en termes de valeur de résistance à l'état passant, concerne la mesure de résistivité ou de résistance le long du chemin de conduction.

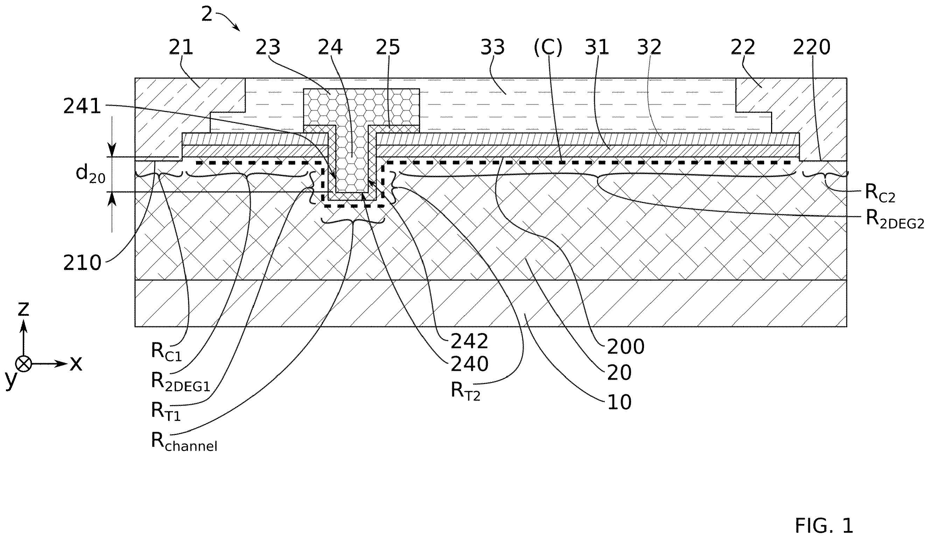

La figure 1 illustre les différentes composantes de résistance $R_{on}$ le long du chemin de conduction (C) entre la source 21 et le drain 22 d'un transistor 2 basé sur l'utilisation d'un gaz bidimensionnel d'électrons (2DEG). Le 2DEG est ici typiquement confiné par effet piézo-électrique sous l'interface entre la couche barrière 31 et le substrat 20. La résistance $R_{on}$ peut se décomposer selon :

$$R_{on} = R_{C1} + \mathrm{R_{2DEG1}} + R_{T1} + R_{Channel} + R_{T2} + \mathrm{R_{2DEG2}} + R_{C2}$$

Avec $R_{on}$ la résistance totale, $R_{C1}$, $R_{C2}$ les résistances de contact source et drain, $R_{Channel}$ la résistance du canal sous la grille, $R_{T1}$, $R_{T2}$ les résistances le long des flancs de la grille, et $R_{2DEG1}$, $R_{2DEG2}$ les résistances dans le 2DEG.

Les méthodes classiques de mesure de résistivité sont typiquement les mesures basées sur un modèle de transfert de ligne (TLM, acronyme de Transfer Line Model), les mesures par Effet Hall, les mesures de type Van der Pauw, ou les mesures à quatre pointes.

La méthode TLM nécessite une structure de test comprenant typiquement quatre contacts séparés par des distances de séparation croissantes.

La mesure par effet Hall nécessite typiquement quatre électrodes et l'application d'un champ magnétique au niveau du transistor analysé.

Les mesures Van der Pauw et quatre pointes sont des variantes nécessitant quatre électrodes placées selon des géométries particulières.

La méthode TLM combinée à la mesure de la résistance totale $R_{on}$ du transistor permet d'obtenir : $R_{T1} + R_{T2} + R_{channel}$, en soustrayant les résistances du 2DEG et des contacts à la résistance totale mesurée sur le transistor.

La méthode Van der Pauw permet de déterminer la valeur de $R_{channel}$. Les méthodes connues permettent ainsi d'obtenir la valeur $R_{T1} + R_{T2}$, et par suite une valeur moyenne $R_T$ correspondant sensiblement à la résistance dans le chemin de conduction le long d'un flanc de la partie enterrée de la grille.

Il n'est cependant pas possible de dissocier les deux composantes de résistances $R_{T1}$ et $R_{T2}$, le long de chacun des flancs de la partie enterrée de la grille, dont la somme est égale à $2R_T$. Or la détermination précise de ces deux composantes $R_{T1}$ et $R_{T2}$ présente un intérêt particulier dans la caractérisation des propriétés électrostatiques du transistor et des états d'interface des flancs de la grille. La détermination précise de $R_{T1}$ et $R_{T2}$ permettrait par exemple d'envisager des solutions technologiques minimisant la résistance totale $R_{on}$.

La détermination des différentes composantes de $R_{on}$ au niveau de chacune des portions de la grille est donc un enjeu important. Il existe un besoin consistant à proposer une méthode et une structure de test surmontant les inconvénients mentionnés ci-dessus.

Un objet de la présente invention est de proposer une structure de test permettant de dissocier les contributions des deux flancs d'une grille enterrée en mesurant séparément et avec précision $R_{T1}$ et $R_{T2}$.

Un autre objet de la présente invention est de proposer une méthode de test permettant de déterminer séparément $R_{T1}$ et $R_{T2}$.

Les autres objets, caractéristiques et avantages de la présente invention apparaîtront à l'examen de la description suivante et des dessins d'accompagnement. Il est entendu que d'autres avantages peuvent être incorporés.

**RESUME**

Pour atteindre cet objectif, selon un mode de réalisation on prévoit une structure de test pour un transistor à grille enterrée, ledit transistor comprenant :

- Un substrat,
- Une grille présentant une partie enterrée dans le substrat,
- Un diélectrique de grille isolant électriquement la grille du substrat,
- Un premier contact de transistor situé d'un premier côté de la grille et présentant une première extrémité connectant un chemin de conduction dans le substrat,
- Un deuxième contact de transistor situé d'un deuxième côté de la grille, opposé au premier côté, et présentant une deuxième extrémité connectant le chemin de conduction dans le substrat.

La structure de test comprend :

- Un premier contact de test situé d'un côté du premier contact de transistor opposé à la grille,
- Un deuxième contact de test situé d'un côté du deuxième contact de transistor opposé à la grille.

Avantageusement, la structure de test comprend en outre :

- une couche enterrée dans le substrat, présentant un dopage supérieur ou égal à 10^18 $cm^{-3}$, par exemple compris entre 10^19 et 10^20 $cm^{-3}$, et présentant une face qui tangente la partie enterrée de la grille,
- une première structure d'isolation configurée pour isoler électriquement entre eux le premier contact de test et le premier contact de transistor,
- une deuxième structure d'isolation configurée pour isoler électriquement entre eux le deuxième contact de test et le deuxième contact de transistor.

Avantageusement, les premier et deuxième contacts de test présentent chacun une extrémité connectant la couche enterrée.

Une telle structure de test permet avantageusement d'établir un chemin de conduction électrique entre le premier contact de transistor et le premier contact de test, passant par la couche enterrée et le premier flanc de la grille.

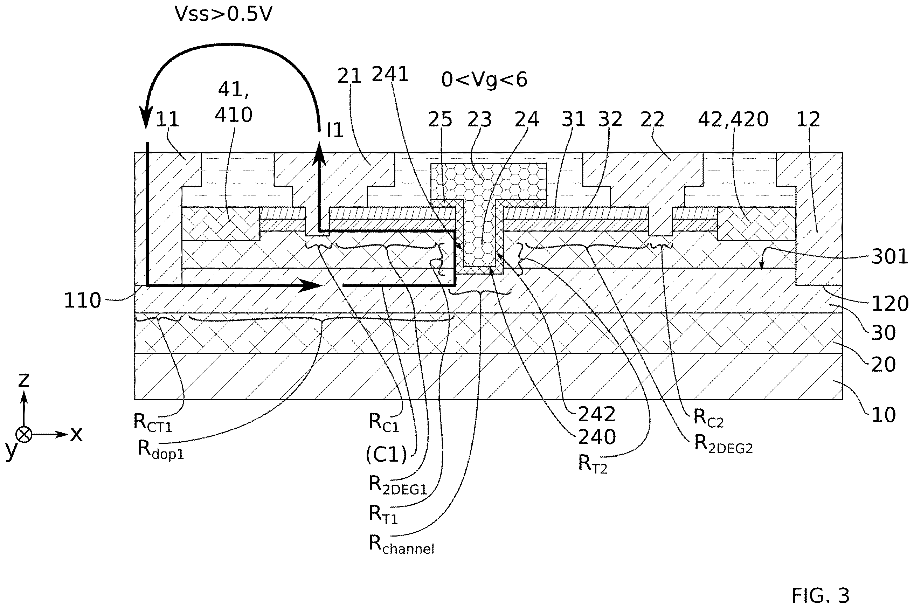

Comme illustré à la figure 3, en polarisant positivement selon $V_{ss}$ le premier contact de test 11 vis-à-vis du premier contact de transistor 21, un courant I1 s'établit et il est ainsi possible de mesurer la résistance $R_{T1}$ le long du premier flanc 241 de la grille 23, selon :

$$R_{T1} = \frac{Vss}{I_1} - R_{2DEG1} - R_{C1} - R_{CT1} - R_{dop1}$$

Avec $V_{ss}$ la tension de polarisation entre le premier contact de test et le premier contact de transistor, $I_1$ le courant électrique, $R_{C1}$ la résistance au niveau du premier contact de transistor, $R_{CT1}$ la résistance au niveau du premier contact de test, $R_{2DEG1}$ la résistance dans le 2DEG entre la grille et le premier contact de transistor, et $R_{dop1}$ la résistance dans la couche enterrée entre la grille et le premier contact de test.

La structure de test permet également de mesurer séparément la résistance $R_{T2}$ le long du deuxième flanc de la grille, en polarisant négativement selon $V_{DD}$ le deuxième contact de test vis-à-vis du deuxième contact de transistor, de façon similaire à la mesure de $R_{T1}$.

$$R_{T2} = \frac{VDD}{I_2} - R_{2DEG2} - R_{C2} - R_{CT2} - R_{dop2}$$

Avec $V_{DD}$ la tension de polarisation entre le deuxième contact de test et le deuxième contact de transistor, $I_2$ le courant électrique, $R_{C2}$ la résistance au niveau du deuxième contact de transistor, $R_{CT2}$ la résistance au niveau du deuxième contact de test, $R_{2DEG2}$ la résistance dans le 2DEG entre la grille et le deuxième contact de transistor, et $R_{dop2}$ la résistance dans la couche enterrée entre la grille et le deuxième contact de test.

La structure de test selon l'invention permet donc de déterminer séparément les résistances $R_{T1}$ et $R_{T2}$ le long de chacun des flancs de la partie enterrée de la grille.

Selon une possibilité, la structure de test permet aussi de déterminer Rct1+Rdop1 (et de manière équivalente Rct2+Rdop2) en polarisant positivement le premier contact de test vis-à-vis du deuxième contact de test, sans polariser les premier et deuxième contacts de transistor ni la grille.

Selon un autre aspect de l'invention, on prévoit un procédé de test mettant en œuvre une structure de test selon le mode de réalisation exposé plus haut, comprenant les étapes suivantes :

- Polariser la grille à une tension de grille Vg comprise entre 0 et 15V,
- Polariser positivement le premier contact de test vis-à-vis du premier contact de transistor, sans polariser le deuxième contact de test ni le deuxième contact de transistor, de façon à déterminer une première valeur de résistance RT1 le long d'un premier flanc de la partie enterrée de la grille,
- Polariser négativement le deuxième contact de test vis-à-vis du deuxième contact de transistor, sans polariser le premier contact de test ni le premier contact de transistor, de façon à déterminer une deuxième valeur de résistance RT2 le long d'un deuxième flanc de la partie enterrée de la grille.

Un premier chemin de conduction est ainsi avantageusement établi entre le premier contact de test et le premier contact de transistor, permettant de déterminer la résistance $R_{T1}$, puis un deuxième chemin de conduction est avantageusement établi entre le deuxième contact de test et le deuxième contact de transistor, permettant de déterminer la résistance $R_{T2}$.

**BREVE DESCRIPTION DES FIGURES**

Les buts, objets, ainsi que les caractéristiques et avantages de l'invention ressortiront mieux de la description détaillée de modes de réalisation de cette dernière qui sont illustrés par les dessins d'accompagnement suivants dans lesquels :

La figure 1 illustre schématiquement un transistor à grille enterrée selon un mode de réalisation de la présente invention. Les résistances le long des différentes portions du chemin de conduction sont indiquées.
La figure 2 illustre schématiquement une structure de test selon un mode de réalisation de la présente invention.
La figure 3 illustre schématiquement un premier chemin de conduction dans la structure de test illustrée à la figure 2, selon un mode de réalisation de la présente invention.
La figure 4 illustre schématiquement un autre chemin de conduction dans une structure de test selon un mode de réalisation de la présente invention.
La figure 5 illustre schématiquement une structure de test selon un autre mode de réalisation de la présente invention.
La figure 6 illustre schématiquement un premier chemin de conduction dans la structure de test illustrée à la figure 5, selon un mode de réalisation de la présente invention.

Les dessins sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques. En particulier, sur les schémas de principe, les épaisseurs des différentes couches, et les dimensions des différents motifs (grille, source, drain etc) ne sont pas représentatives de la réalité.

**DESCRIPTION DÉTAILLÉE**

Avant d'entamer une revue détaillée de modes de réalisation de l'invention, sont énoncées ci-après des caractéristiques optionnelles qui peuvent éventuellement être utilisées en association ou alternativement :
Selon un exemple, la structure de test pour un transistor à grille enterrée comprend ledit transistor.

Selon un exemple, les première et deuxième structures d'isolation comprennent respectivement des première et deuxième zones amorphes.

Selon un exemple, les première et deuxième structures d'isolation comprennent respectivement des premier et deuxième caissons à base d'un matériau diélectrique.

Selon un exemple, les première et deuxième structures d'isolation comprennent respectivement des première et deuxième grilles disposées en surface du substrat. Ces grilles sont typiquement séparées de la surface du substrat par une couche diélectrique. Elles ne sont pas nécessairement directement au contact de la surface du substrat.

Selon un exemple, la face de la couche enterrée passe au sein du diélectrique de grille situé sous une extrémité de la grille enterrée. Cette face est configurée pour être à proximité immédiate de l'extrémité basse de la grille, typiquement au niveau de la portion du chemin de conduction correspondant à $R_{Channel}$. Aux tolérances de fabrication près, cette face peut être sensiblement tangente à l'extrémité basse de la grille ou à l'extrémité basse du diélectrique de grille, ou entre les deux plans contenant ces deux extrémités basses, au sein du diélectrique de grille.

Selon un exemple, le transistor à grille enterrée comprend une couche barrière sur le substrat configurée pour former un gaz bidimensionnel d'électrons (2DEG) confiné sous ladite couche barrière, dans le substrat.

Selon un exemple, le gaz 2DEG forme le chemin de conduction, les premier et deuxième contacts de transistor traversant ladite couche barrière.

Selon un exemple, le substrat est à base de GaN et la couche enterrée est à base de GaN dopé N.

Selon un exemple alternatif, le substrat est à base de silicium ou de carbure de silicium.

Selon un exemple, la couche enterrée présente une épaisseur $e_{30}$ supérieure ou égale à 100 nm.

Selon un exemple, les premier et deuxième contacts de transistor sont disposés symétriquement de part et d'autre de la grille.

Selon un exemple, les premier et deuxième contacts de test sont disposés symétriquement de part et d'autre de la grille.

Selon un exemple, la structure de test comprend un transistor à grille enterrée, ledit transistor comprenant :

- Un substrat,
- Une grille présentant une partie enterrée dans le substrat,
- Un diélectrique de grille isolant électriquement la grille du substrat,
- Un premier contact de transistor situé d'un premier côté de la grille et présentant une première extrémité connectant un chemin de conduction dans le substrat,
- Un deuxième contact de transistor situé d'un deuxième côté de la grille, opposé au premier côté, et présentant une deuxième extrémité connectant le chemin de conduction dans le substrat,

Et la structure de test comprend :

- Un premier contact de test situé d'un côté du premier contact de transistor opposé à la grille,
- Un deuxième contact de test situé d'un côté du deuxième contact de transistor opposé à la grille,
- Une couche enterrée dans le substrat, présentant un dopage supérieur ou égal à $10^{18}$ $cm^{-3}$, par exemple compris entre $10^{19}$ et $10^{20}$ $cm^{-3}$, et présentant une face qui tangente la partie enterrée de la grille,
- Une première structure d'isolation configurée pour isoler électriquement entre eux le premier contact de test et le premier contact de transistor,
- Une deuxième structure d'isolation configurée pour isoler électriquement entre eux le deuxième contact de test et le deuxième contact de transistor, les premier et deuxième contacts de test présentant chacun une extrémité connectant la couche enterrée.

Selon un exemple, le procédé comprend en outre :

- Polariser positivement le premier contact de test vis-à-vis du deuxième contact de test, sans polariser les premier et deuxième contacts de transistor ni la grille, de façon à déterminer une valeur de résistance, typiquement 2.RCT + 2.Rdop, de la couche enterrée entre les premier et deuxième contacts de test.

Selon un exemple, le procédé comprend en outre :

- Lors de la détermination de la première valeur de résistance RT1, polariser négativement la première grille de la première structure d'isolation, en-dessous d'une première tension de seuil Vth1, de manière à bloquer un passage de courant électrique entre le premier contact de test et le premier contact de transistor,
- Lors de la détermination de la deuxième valeur de résistance RT2, polariser négativement la deuxième grille de la deuxième structure d'isolation, en-dessous d'une deuxième tension de seuil Vth2, de manière à bloquer un passage de courant électrique entre le deuxième contact de test et le deuxième contact de transistor.

Sauf incompatibilité, des caractéristiques techniques décrites en détail pour un mode de réalisation donné peuvent être combinées aux caractéristiques techniques décrites dans le contexte d'autres modes de réalisation décrits à titre exemplaire et non limitatif, de manière à former un autre mode de réalisation qui n'est pas nécessairement illustré ou décrit. Un tel mode de réalisation n'est évidemment pas exclu de l'invention.

Dans le cadre de la présente invention, les architectures de transistors de puissance envisagées sont typiquement à grille enterrée dans le substrat. Certaines de ces architectures sont plus particulièrement basées sur un principe de conduction par gaz bidimensionnel d'électrons (2DEG).

Une telle architecture de transistor inclut la superposition de deux couches semi-conductrices ayant des bandes interdites différentes qui forment un puit quantique à leur interface. Des électrons sont confinés dans ce puits quantique pour former un gaz bidimensionnel d'électrons.

Les transistors de type HEMT (acronyme de « High Electron Mobility transistor », qui signifie transistor à effet de champ à haute mobilité d'électrons), parfois également désignés par le terme de transistor à effet de champ à hétérostructure, sont des exemples de transistors basés sur cette architecture à gaz bidimensionnel d'électrons.

Pour des raisons de tenue en puissance (en particulier haute tension) et en température, le matériau semi-conducteur de ces transistors est de préférence choisi de façon à présenter une large bande d'énergie interdite. Parmi les transistors HEMT à large bande d'énergie interdite, les transistors à base de nitrure de gallium sont généralement préférés.

Dans le cadre de la présente invention, le passage du courant est typiquement piloté par une grille polarisée positivement par rapport à la source.

Cette grille peut être de type MOS ou MOSFET (acronyme anglais de « Metal Oxide Semiconductor Field Effect Transistor ») ou bien encore de manière plus générale MIS ou MISFET (« Metal Insulator Semiconductor »). Dans ce cas, la grille métallique est isolée électriquement des couches semi-conductrices par un diélectrique de grille. D'autres compositions de grille peuvent être envisagées. Une particularité des architectures de transistors selon la présente invention est que la grille traverse le puit quantique au niveau duquel est confiné le gaz bidimensionnel d'électrons. La continuité du gaz bidimensionnel d'électrons est ainsi rompue par une tranchée dans laquelle est réalisée la grille MOS du transistor.

Généralement, si la grille du transistor est mise à une tension supérieure à une tension seuil, la source et le drain sont connectés par le gaz bidimensionnel d'électrons et le transistor est dit passant.

Si la grille du transistor est mise à une tension inférieure à la tension seuil, la source et le drain ne sont plus connectés et le transistor est dit bloqué.

Les transistors HEMT à grille enterrée envisagés dans le cadre de l'invention sont de préférence à l'état bloqué lorsque la grille n'est pas polarisée. Ce type de fonctionnement de transistor est couramment désigné par « normally off » (normalement bloqué).

Il est précisé que, dans le cadre de la présente invention, les termes « sur », « surmonte », « recouvre », « sous-jacent », en « vis-à-vis » et leurs équivalents ne signifient pas forcément « au contact de ». Ainsi par exemple, le dépôt d'une première couche sur une deuxième couche, ne signifie pas obligatoirement que les deux couches sont directement au contact l'une de l'autre, mais signifie que la première couche recouvre au moins partiellement la deuxième couche en étant soit directement à son contact, soit en étant séparée d'elle par au moins une autre couche ou au moins un autre élément.

Par exemple et de façon connue en soi dans le domaine des transistors de type HEMT à base de GaN, une fine couche en AlN peut être intercalée entre deux couches semi-conductrices en GaN et en AlGaN.

Une couche peut par ailleurs être composée de plusieurs sous-couches d'un même matériau ou de matériaux différents.

On entend par un substrat, un empilement, une couche, « à base » d'un matériau A, un substrat, un empilement, une couche comprenant ce matériau A uniquement ou ce matériau A et éventuellement d'autres matériaux, par exemple des éléments d'alliage et/ou des éléments dopants.

Les gammes de dopage associées aux différents types de dopage indiqués dans la présente demande sont les suivantes :

- dopage p++ ou n++ : supérieur à $1 \times 10^{\wedge}20 cm^{-3}$
- dopage p+ ou n+ : $1 \times 10^{\wedge}18\ cm^{-3}$ à $9 \times 10^{\wedge}19\ cm^{-3}$
- dopage p ou n : $1 \times 10^{\wedge}17\ cm^{-3}$ à $1 \times 10^{\wedge}18\ cm^{-3}$
- dopage intrinsèque ou non intentionnellement dopé: $1.10^{\wedge}15\ cm^{-3}$ à $1.10^{\wedge}17\ cm^{-3}$

Un repère de préférence orthonormé, comprenant les axes x, y, z est représenté sur les figures annexées. Lorsqu'un seul repère est représenté sur une même planche de figures, ce repère s'applique à toutes les figures de cette planche.

Dans la présente demande de brevet, l'épaisseur d'une couche est prise selon une direction normale au plan d'extension principal de la couche. Ainsi, une couche présente typiquement une épaisseur selon z. Les termes relatifs « sur », « surmonte », « sous », « sous-jacent » se réfèrent à des positions prises selon la direction z.

Les termes « vertical », « verticalement » se réfèrent à une direction selon z. Les termes « horizontal », « horizontalement » se réfèrent à une direction dans le plan xy.

Un élément situé « à l'aplomb » ou « au droit d'» un autre élément signifie que ces deux éléments sont situés tous deux sur une même ligne perpendiculaire à un plan dans lequel s'étend principalement une face inférieure ou supérieure d'un substrat, c'est-à-dire sur une même ligne orientée verticalement sur les figures.

Un exemple de transistor 2 à grille enterrée selon la présente invention est illustré à la figure 1. L'architecture générale de ce transistor 2 de type HEMT comprend un premier contact, par exemple une source 21 et un deuxième contact, par exemple un drain 22 formés de part et d'autre d'un motif de grille ou grille 23. La grille 23 s'étend en partie au travers d'un empilement de couches 32, 31, jusque dans le substrat 20. Ce transistor 2 est basé sur un principe de conduction par gaz bidimensionnel d'électrons (2DEG). D'autres types de transistors à grille enterrée sont également envisageables.

Le substrat 20 peut être un substrat à base de GaN. Des substrats connus de GaN sur saphir ou de GaN sur silicium peuvent typiquement être utilisés. Le support 10 peut ainsi comprendre de façon connue une partie massive en silicium et une ou plusieurs couches tampon intercalées entre la partie en silicium et le substrat 20 à base de GaN. Le substrat 20 est typiquement non intentionnellement dopé.

Une couche barrière 31, typiquement à base d'AlGaN, est directement disposée en surface 200 du substrat 20. Cette couche barrière 31 présente une épaisseur par exemple comprise entre 20 nm et 100 nm.

De façon connue, un gaz bidimensionnel d'électrons se forme sous la couche barrière 31 à base d'AlGaN, dans le substrat 20 à base de GaN. Le gaz bidimensionnel d'électrons 2DEG est typiquement confiné à l'interface entre la couche barrière 31 à base d'AlGaN et le substrat 20 à base de GaN. Ce gaz bidimensionnel d'électrons 2DEG forme un chemin de conduction (C) dans le substrat 20.

Une couche diélectrique 32, par exemple à base de nitrure de silicium SiN, est typiquement disposée sur la couche barrière 31.

Une couche d'encapsulation 33, par exemple à base d'oxyde de silicium SiO2, peut être typiquement formée sur la couche 32, entre les contacts 21, 22 et la grille 23, de manière à isoler les contacts et la grille entre eux, et pour planariser la structure.

De façon connue, l'empilement de couches 31, 32 à la surface 200 du substrat 20 peut comprendre d'autres couches, par exemple une fine couche à base d'AlN entre le substrat 20 et la couche barrière 31.

La grille 23 est typiquement disposée sur cet empilement de couches 31, 32, et comprend une partie 24 traversant l'empilement et s'étendant jusque dans le substrat 20, dite partie enterrée 24. La partie enterrée 24 de la grille 23 présente une extrémité inférieure 240, et cette extrémité inférieure 240 est située à une profondeur d20 selon z, dans le substrat 20, par rapport à la surface 200 du substrat 20. L'extrémité 240 peut être située à une profondeur d20 comprise entre 20nm et 100nm. La partie enterrée 24 de la grille 23 présente typiquement un premier flanc 241, par exemple sensiblement vertical, et un deuxième flanc 242, par exemple sensiblement vertical, sous la surface 200 du substrat 20. La grille 23, 24 peut être à base d'un alliage métallique, par exemple à base d'or et/ou de platine et/ou de titane.

Un diélectrique de grille 25 sépare typiquement la grille 23, 24 de l'empilement de couches 31, 32 et du substrat 20. Ce diélectrique de grille 25 est par exemple à base d'alumine Al2O3, et présente une épaisseur de l'ordre de quelques nanomètres à quelques dizaines de nanomètres, par exemple de l'ordre de 30 nm.

La partie enterrée 24 de la grille 23 est configurée pour interrompre le gaz bidimensionnel d'électrons le long du chemin de conduction (C). Le contrôle de la tension de grille Vg permet d'autoriser ou de bloquer le passage des électrons du gaz bidimensionnel d'électrons de part et d'autre de la grille 23. La tension de grille Vg permettant d'autoriser le passage des électrons est ici typiquement positive, par exemple comprise entre 0V et 15V. Selon un exemple la tension de grille Vg permettant d'autoriser le passage des électrons est comprise entre 0V et 6V. En l'absence de polarisation de la grille 23, ce type de transistor 2 est configuré de façon à ce que le passage des électrons soit bloqué. Ce type de transistor 2 est dit « normally off ».

Les contacts source et drain 21, 22 présentent respectivement une extrémité 210, 220 directement au contact du substrat 20. Le premier contact de transistor 21 se trouve typiquement du côté du premier flanc 241, et le deuxième contact de transistor 22 se trouve typiquement du côté du deuxième flanc 242.

La résistance totale $R_{on}$ du transistor 2 peut se décomposer le long des différentes portions du chemin de conduction (C) depuis la source 21 jusqu'au drain 22, comme suit :

$$R_{on} = R_{C1} + \mathrm{R}_{\mathrm{2DEG1}} + R_{T1} + R_{Channel} + R_{T2} + \mathrm{R}_{\mathrm{2DEG2}} + R_{C2}$$

Avec $R_{C1}$ la résistance de contact au niveau du premier contact 21, $R_{2DEG1}$ la résistance dans le gaz 2DEG entre le premier contact 21 et la partie enterrée 24 de la grille 23, $R_{T1}$ la résistance le long du premier flanc 241 de la partie enterrée 24 de la grille 23, $R_{Channel}$ la résistance sous l'extrémité 240 de la partie enterrée 24 de la grille 23, $R_{T2}$ la résistance le long du deuxième flanc 242 de la partie enterrée 24 de la grille 23, $R_{2DEG2}$ la résistance dans le gaz 2DEG entre la partie enterrée 24 de la grille 23 et le deuxième contact 22, et $R_{C2}$ la résistance de contact au niveau du deuxième contact 22.

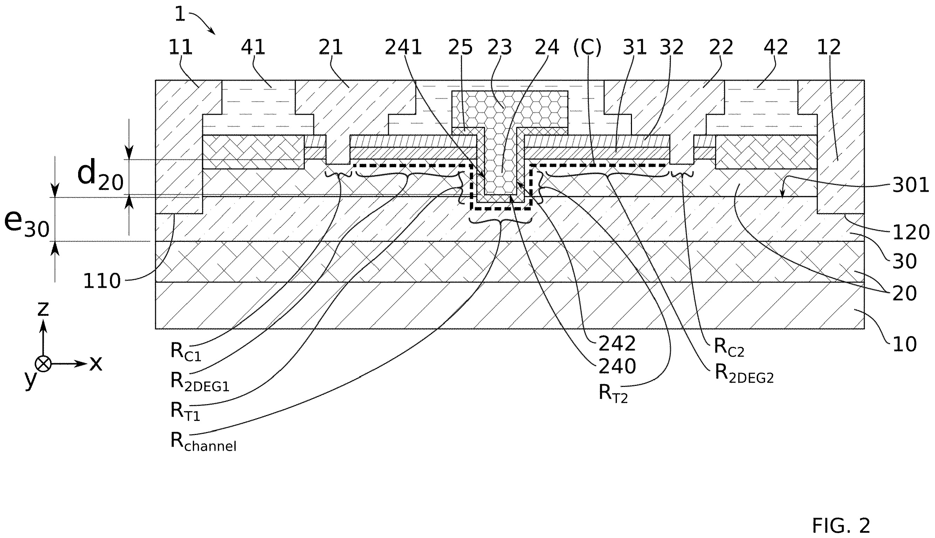

Comme illustré à la figure 2, une structure de test 1 dédiée à la mesure des composantes $R_{T1}$, $R_{T2}$ du transistor 2 est proposée.

La structure de test 1 comprend typiquement des premiers et deuxième contacts de test 11, 12, et une couche 30 enterrée dans le substrat 20. Les premier et deuxième contacts de test 11, 12 encadrent typiquement le transistor 2. En particulier, la structure de test 1 est configurée de manière à ce que la grille 23, 24 et les contacts de transistor 21, 22 soient situés entre les premier et deuxième contacts de test 11, 12.

Dans cette configuration, le premier contact de transistor 21 est situé entre le premier contact de test 11 et la grille 23. Le deuxième contact de transistor 22 est situé entre le deuxième contact le test 12 et la grille 23.

Les premiers et deuxièmes contacts de test 11, 12 s'étendent dans le substrat 20 jusqu'à la couche enterrée 30. Ils présentent chacun une extrémité 110, 120 située au sein de la couche enterrée 30. Les premiers et deuxième contacts de test 11, 12 sont respectivement isolés électriquement vis-à-vis des premiers et deuxième contacts de transistor 21, 22, par des structures d'isolation 41, 42.

La couche enterrée 30 est électriquement conductrice. Elle est typiquement à base d'un semi-conducteur fortement dopé, présentant typiquement un dopage supérieur à $10^{18}$ $cm^{-3}$, par exemple compris entre $10^{19}$ et $10^{20}$ $cm^{-3}$. Ainsi, pour un substrat 20 à base de GaN, une couche enterrée 30 à base de GaN dopée n+ ou n++ est avantageusement choisie, afin de conserver la qualité cristalline du substrat 20. Une telle couche 30 peut être réalisée pendant l'épitaxie du substrat 20 par croissance MOCVD (« Metal Oraganic Chemical Vapor Déposition » signifiant dépôt chimique en phase vapeur à précurseurs organométalliques), typiquement en incorporant du silicium. Le silicium est un dopant de type n (atomes donneurs) pour le GaN. Le dopage du GaN par le silicium peut se faire lors de la croissance à 1050°C, sans qu'il soit nécessaire de réaliser de recuit d'activation. La couche enterrée 30 présente une épaisseur $e_{30}$ selon z de préférence supérieure à 100 nm, par exemple comprise entre 100 et 400 nanomètres. Les résistances $R_{dop1}$, $R_{dop2}$ liées à cette couche 30 sont d'autant plus faibles que le dopage est élevé et que l'épaisseur $e_{30}$ est importante.

La couche enterrée 30 présente une face supérieure 301 configurée pour venir tangenter l'extrémité 240 de la partie enterrée 24 de la grille 23. Selon une possibilité, la face 301 passe au sein du diélectrique 25 situé sous l'extrémité 240 de la grille. Selon une autre possibilité la face 301 tangente l'extrémité 250 du diélectrique de grille 25. Le positionnement de la face 301 de la couche 30 est choisi de façon à ce que la couche 30 intercepte le chemin de conduction du transistor 2, au niveau de la portion la plus basse du chemin de conduction correspondant à $R_{Channel}$. La position tangentielle de cette face 301 vis-à-vis de l'extrémité de la grille 24 ou du diélectrique de grille 25 permet de conserver la totalité ou la majeure partie des portions du chemin de conduction correspondant à $R_{T1}$, $R_{T2}$ le long des flancs 241, 242 de la partie enterrée 24 de la grille. Cela permet d'améliorer la précision sur la mesure des valeurs $R_{T1}$, $R_{T2}$. La précision sur le positionnement en profondeur de la face 301 vis-à-vis des extrémités 240, 250 est typiquement de l'ordre de quelques nanomètres, par exemple inférieure à 5 nm, et de préférence inférieure à 2 nm.

Selon une possibilité, la structure de test 1 comprenant le transistor 2 présente une symétrie par rapport à la grille 23. Comme illustré à la figure 2, les contacts de transistors 21, 22 sont de préférence équidistants de la grille 23. Dans ce cas, $R_{2DEG1} \approx R_{2DEG2}$. Les contacts de test 11, 12 sont de préférence équidistants de la grille 23. Dans ce cas, $R_{dop1} \approx R_{dop2}$.

Les structures d'isolation 41, 42 sont configurées pour isoler électriquement respectivement les contacts de test 11, 12 vis-à-vis des contacts de transistor 21, 22. Plusieurs modes de réalisation de ces structures d'isolation 41, 42 sont décrits dans la suite.

La figure 3 illustre un mode de réalisation où les structures d'isolation 41, 42 sont formés typiquement par implantation d'argon au travers des couches 31, 32, jusque dans le substrat 20. Cette implantation est configurée pour amorphiser localement les zones 410, 420 s'étendant au travers des couches 31, 32, et en partie dans le substrat 20 sur une profondeur supérieure à l'épaisseur de confinement du 2DEG. Ainsi, le gaz bidimensionnel d'électrons est détruit au niveau des zones d'isolation 41, 42. Il n'y a donc pas de chemin de conduction entre le premier contact de test 11 et le premier contact de transistor 21 d'une part, et entre le deuxième contact de test 12 et le deuxième contact de transistor 22 d'autres part. Une telle implantation peut être réalisée via une énergie d'implantation de plusieurs dizaines de keV, typiquement de l'ordre de 60 keV.

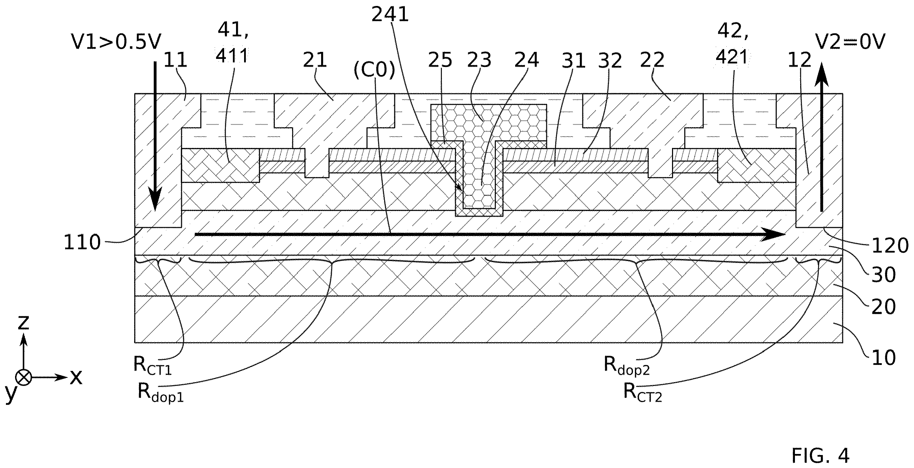

La figure 4 illustre un autre mode de réalisation où les structures d'isolation 41, 42 sont formés par des caissons d'isolation 411, 421. Comme précédemment, ces caissons 411, 421 sont configurés pour s'étendre au travers des couches 31, 32, et en partie dans le substrat 20 sur une profondeur supérieure à l'épaisseur de confinement du 2DEG. Cela permet de supprimer localement le 2DEG et le chemin de conduction entre les contacts de test et les contacts de transistors. Les caissons 411, 421 peuvent être formés par gravure chimique, puis remplis par un matériau diélectrique, par exemple SiO2 ou SiN.

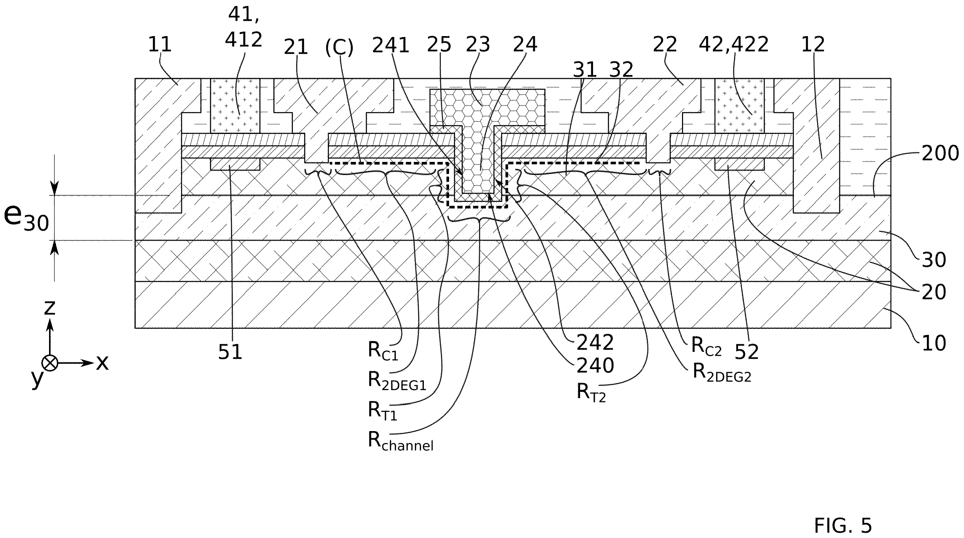

La figure 5 illustre un autre mode de réalisation où les structures d'isolation 41, 42 sont formés par des transistors 412, 422 disposés à la surface 200 du substrat 20. Dans ce mode de réalisation, il n'est pas nécessaire de structurer le substrat 20 sous la surface 200. Typiquement, les grilles des transistors 412, 422 sont formées sur la couche 32, respectivement entre le premier contact de test 11 et le premier contact de transistor 21, et entre le deuxième contact de test 12 et le deuxième contact de transistor 22. Les transistors 412, 422 ainsi formés sont typiquement de type « Nomally-ON » (normalement passant). Il est donc possible de bloquer la conduction entre le premier contact de test 11 et le premier contact de transistor 21, et entre le deuxième contact de test 12 et le deuxième contact de transistor 22, en polarisant négativement les grilles des transistors 412, 422 en dessous des tensions de seuil Vth de ces transistors 412, 422. Les tensions de seuil Vth de ces transistors 412, 422 sont typiquement de l'ordre de - 8V. Ainsi, en polarisant les grilles des transistors 412, 422 par exemple à Vgs = -15V par rapport aux contacts de transistors 21, 22, des zones déplétées 51, 52 apparaissent et bloquent la conduction sous les grilles des transistors 412, 422.

La structure de test 1 peut avantageusement être mise en œuvre afin de mesurer séparément $R_{T1}$ et $R_{T2}$.

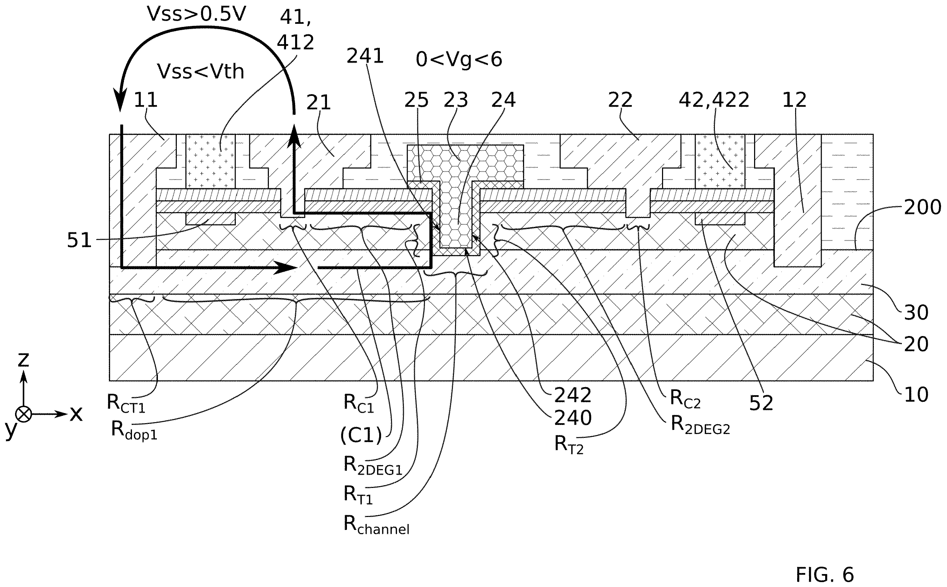

Comme illustré aux figures 3 et 6 pour différents modes de réalisation des structures d'isolation 41, 42, en polarisant positivement le premier contact de test 11 vis-à-vis du premier contact de transistor 21, par exemple selon Vss > 0,5V, un courant I1 s'établit le long du chemin de conduction (C1) correspondant aux portions de résistance $R_{CT1}$, $R_{dop1}$, $R_{T1}$, $R_{2DEG1}$, $R_{C1}$. Il est alors possible de déterminer la résistance $R_{T1}$ le long du flanc 241 de la partie enterrée 24 de la grille 23, selon :

$$R_{T1} = \frac{Vss}{I_1} - R_{2DEG1} - R_{C1} - R_{CT1} - R_{dop1}$$

Les résistances $R_{2DEG1}$, $R_{C1}$ peuvent être déterminées par ailleurs, par exemple selon les méthodes connues citées plus haut.

La somme des résistances $R_{dop1} + R_{CT1}$ peut être avantageusement déterminée via la même structure de test 1, en modifiant les connexions et polarisations des différents contacts 11, 21, 23, 22, 12.

Comme illustré à la figure 4, en polarisant positivement le premier contact de test 11 vis-à-vis du deuxième contact de test 12, par exemple avec V1 > 0,5V et V2 = 0V, sans polariser les contacts de transistor 21, 22 et la grille 23, un courant I s'établit le long du chemin de conduction (C0) correspondant aux portions de résistance $R_{CT1}$, $R_{dop1}$, $R_{dop2}$, $R_{CT2}$. Il est alors possible de déterminer la somme des résistances $R_{dop1} + R_{CT1} + R_{dop2} + R_{CT2}$, qui, dans le cas d'une structure de test symétrique, est sensiblement égale à $2.R_{CT} + 2.R_{dop}$, selon :

$$\frac{V1 - V2}{I} = R_{CT1} + R_{dop1} + R_{CT2} + R_{dop2}$$

Dans le cas d'une structure de test symétrique comme illustrée en figure 4, $R_{dop1} \approx R_{dop2} \approx R_{dop}$ et $R_{CT1} \approx R_{CT2} \approx R_{CT}$.

Il est ainsi possible d'extraire $R_{dop1} + R_{CT1}$ selon :

$$R_{CT1} + R_{dop1} = R_{CT} + R_{dop} = \frac{V1 - V2}{2I}$$

La structure de test 1 permet ainsi de déterminer isolément $R_{T1}$.

De façon similaire, la structure de test 1 permet de déterminer isolément $R_{T2}$, en polarisant positivement le deuxième contact de test 12 vis-à-vis du deuxième contact de transistor 22 (non illustré).

L'invention n'est pas limitée aux modes de réalisations précédemment décrits.

## Revendications

**1.** Structure de test (1) pour un transistor (2) à grille (23) enterrée, ledit transistor (2) comprenant :

- Un substrat (20),
- Une grille (23) présentant une partie (24) enterrée dans le substrat (20),
- Un diélectrique de grille (25) isolant électriquement la grille (23) du substrat (20),
- Un premier contact (21) de transistor situé d'un premier côté de la grille (23) et présentant une première extrémité (210) connectant un chemin de conduction (C) dans le substrat (20),
- Un deuxième contact (22) de transistor situé d'un deuxième côté de la grille (23), opposé au premier côté, et présentant une deuxième extrémité (220) connectant le chemin de conduction (C) dans le substrat (20),

Ladite structure de test (1) comprenant :

- Un premier contact (11) de test situé d'un côté du premier contact (21) de transistor opposé à la grille (23),
- Un deuxième contact (12) de test situé d'un côté du deuxième contact (22) de transistor opposé à la grille (23),

Ladite structure de test (1) étant **caractérisée en ce qu'**elle comprend en outre :

- une couche (30) enterrée dans le substrat (20), présentant un dopage supérieur ou égal à $10^{18}$ $cm^{-3}$, par exemple compris entre $10^{19}$ et $10^{20}$ $cm^{-3}$, et présentant une face (301) qui tangente la partie (24) enterrée de la grille (23),
- une première structure d'isolation (41) configurée pour isoler électriquement entre eux le premier contact (11) de test et le premier contact (21) de transistor,
- une deuxième structure d'isolation (42) configurée pour isoler électriquement entre eux le deuxième contact (12) de test et le deuxième contact (22) de transistor,

et **en ce que** les premier et deuxième contacts (11, 12) de test présentent chacun une extrémité (110, 120) connectant la couche (30) enterrée.

2. Structure de test (1) selon la revendication précédente dans laquelle les première et deuxième structures d'isolation (41, 42) comprennent respectivement des première et deuxième zones (410, 420) amorphes.

3. Structure de test (1) selon l'une quelconque des revendications précédentes dans laquelle les première et deuxième structures d'isolation (41, 42) comprennent respectivement des premier et deuxième caissons (411, 421) à base d'un matériau diélectrique.

4. Structure de test (1) selon la revendication 1 dans laquelle les première et deuxième structures d'isolation (41, 42) comprennent respectivement des première et deuxième grilles (412, 422) disposées en surface (200) du substrat (20).

5. Structure de test (1) selon l'une quelconque des revendications précédentes dans laquelle la face (301) de la couche (30) enterrée passe au sein du diélectrique de grille (25) situé au niveau d'une extrémité (240) de la grille (23) enterrée.

6. Structure de test (1) selon l'une quelconque des revendications précédentes dans laquelle le transistor (2) à grille enterrée comprend une couche barrière (31) sur le substrat (20) configurée pour former un gaz bidimensionnel d'électrons (2DEG) confiné sous ladite couche barrière (31), dans le substrat (20), dans lequel le gaz 2DEG forme le chemin de conduction (C), les premier et deuxième contacts (21, 22) de transistor traversant ladite couche barrière (31).

7. Structure de test (1) selon la revendication précédente dans laquelle le substrat (20) est à base de GaN et la couche (30) enterrée est à base de GaN dopé N.

8. Structure de test (1) selon l'une quelconque des revendications précédentes dans laquelle la couche (30) enterrée présente une épaisseur $e_{30}$ supérieure ou égale à 100 nm.

9. Structure de test (1) selon l'une quelconque des revendications précédentes dans laquelle les premier et deuxième contacts (21, 22) de transistor sont disposés symétriquement de part et d'autre de la grille (23), et dans laquelle les premier et deuxième contacts (11, 12) de test sont disposés symétriquement de part et d'autre de la grille (23).

10. Procédé de test mettant en œuvre une structure de test (1) selon l'une quelconque des revendications précédentes, comprenant les étapes suivantes :

- Polariser la grille (23) à une tension de grille Vg comprise entre 0 et 15V,
- Polariser positivement le premier contact (11) de test vis-à-vis du premier contact (21) de transistor, sans polariser le deuxième contact (12) de test ni le deuxième contact (22) de transistor, de façon à déterminer une première valeur de résistance $R_{T1}$ le long d'un premier flanc (241) de la partie enterrée (24) de la grille (23),
- Polariser négativement le deuxième contact (12) de test vis-à-vis du deuxième contact (22) de transistor, sans polariser le premier contact (11) de test ni le premier contact (21) de transistor, de façon à déterminer une deuxième valeur de résistance $R_{T2}$ le long d'un deuxième flanc (242) de la partie enterrée (24) de la grille (23).

11. Procédé selon la revendication précédente comprenant en outre :

- Polariser positivement le premier contact (11) de test vis-à-vis du deuxième contact (12) de test, sans polariser les premier et deuxième contacts (21, 22) de transistor ni la grille (23), de façon à déterminer une valeur de résistance, typiquement $2.R_{CT} + 2.R_{dop}$, le long de la couche enterrée (30) entre les premier et deuxième contacts (11, 12) de test.

**12.** Procédé selon les revendications 4 et 10 en combinaison comprenant en outre :

- Lors de la détermination de la première valeur de résistance $R_{T1}$, polariser négativement la première grille (412) de la première structure d'isolation (41), en-dessous d'une première tension de seuil $V_{th1}$, de manière à bloquer un passage de courant électrique entre le premier contact (11) de test et le premier contact (21) de transistor,
- Lors de la détermination de la deuxième valeur de résistance $R_{T2}$, polariser négativement la deuxième grille (422) de la deuxième structure d'isolation (42), en-dessous d'une deuxième tension de seuil $V_{th2}$, de manière à bloquer un passage de courant électrique entre le deuxième contact (12) de test et le deuxième contact (22) de transistor.

2
21
23
24
25
33
(C)
31
32
22
220
$R_{C2}$
$R_{2DEG2}$
200
20
10
242
240
$R_{T2}$
$R_{C1}$
$R_{2DEG1}$
$R_{T1}$
$R_{channel}$
241
$d_{20}$
210
x
z
y

FIG. 1

1
11
41
21
241
25
23
24
(C)
31
32
22
42
12
301
120
30
20
10
R_C2
R_2DEG2
242
240
R_T2
R_C1
R_2DEG1
R_T1
R_channel
110
d20
e30
x
z
y

FIG. 2

301
120
30
20
10
12
42,420
22
32
31
24
23
25
241
21
0<Vg<6
242
240
I1
Vss>0.5V
41,
410
11
110
$R_{C2}$
$R_{2DEG2}$
$R_{T2}$
$R_{C1}$
(C1)
$R_{2DEG1}$
$R_{T1}$
$R_{channel}$
$R_{CT1}$
$R_{dop1}$
x
z
y

FIG. 3

V2=0V
12
42,
421
22
32
31
24
23
25
241
(C0)
21
41,
411
11
V1>0.5V
110
120
30
20
10
$R_{dop2}$
$R_{CT2}$
$R_{CT1}$
$R_{dop1}$
x
y
z

FIG. 4

200
30
20
10
12
42,422
52
22
$R_{C2}$
$R_{2DEG2}$
32
31
242
240
$R_{T2}$
24
23
25
241
(C)
21
41,
412
11
51
$R_{C1}$
$R_{2DEG1}$
$R_{T1}$
$R_{channel}$
$e_{30}$
x
z
y

FIG. 5

200
30
20
10
12
42,422
52
22
$R_{C2}$
$R_{2DEG2}$
242
240
$R_{T2}$
0<Vg<6
24
23
25
241
$R_{C1}$
(C1)
$R_{2DEG1}$
$R_{T1}$
$R_{channel}$
21
41,
412
Vss>0.5V
Vss<Vth
11
$R_{CT1}$
$R_{dop1}$
51
x
z
y


FIG. 6

Europäisches
Patentamt
European
Patent Office
Office européen
des brevets

# RAPPORT DE RECHERCHE EUROPEENNE

Numéro de la demande
EP 22 21 1347

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X<br>A | US 6 072 209 A (NOBLE WENDELL P [US] ET AL) 6 juin 2000 (2000-06-06)<br>* figures 1-8 *<br>* colonne 1, ligne 17 - ligne 33 *<br>* colonne 3, ligne 36 - colonne 8, ligne 31 *<br>----- | 1-9<br>10-12 | INV.<br>G01R31/26<br>G01R31/27<br>G01R27/14<br>H01L29/778 |
| X | US 2010/025730 A1 (HEIKMAN STEN [US] ET AL) 4 février 2010 (2010-02-04)<br>* figures 1-9 *<br>* alinéa [0054] - alinéa [0090] *<br>----- | 1,7 | |
| | | | **DOMAINES TECHNIQUES RECHERCHES (IPC)** |
| | | | G01R<br>H01L |

Le présent rapport a été établi pour toutes les revendications

| Lieu de la recherche | Date d'achèvement de la recherche | Examinateur |
|---|---|---|
| Munich | 27 mars 2023 | Sedlmaier, Stefan |

2

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
..........................................................................................................
& : membre de la même famille, document correspondant

EPO FORM 1503 03.82 (P04C02)

## ANNEXE AU RAPPORT DE RECHERCHE EUROPEENNE RELATIF A LA DEMANDE DE BREVET EUROPEEN NO.

EP 22 21 1347

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

27-03-2023

| Document brevet cité au rapport de recherche | Date de publication | Membre(s) de la famille de brevet(s) | Date de publication |
|---|---|---|---|
| US 6072209 A | 06-06-2000 | US 6072209 A | 06-06-2000 |
| | | US 6476434 B1 | 05-11-2002 |
| | | US 6689660 B1 | 10-02-2004 |
| US 2010025730 A1 | 04-02-2010 | CN 102171830 A | 31-08-2011 |
| | | EP 2311095 A2 | 20-04-2011 |
| | | EP 2571057 A2 | 20-03-2013 |
| | | JP 5576369 B2 | 20-08-2014 |
| | | JP 6357037 B2 | 11-07-2018 |
| | | JP 2011529639 A | 08-12-2011 |
| | | JP 2014222763 A | 27-11-2014 |
| | | KR 20110041550 A | 21-04-2011 |
| | | US 2010025730 A1 | 04-02-2010 |
| | | US 2011263102 A1 | 27-10-2011 |
| | | US 2012235160 A1 | 20-09-2012 |
| | | WO 2010014128 A2 | 04-02-2010 |

EPO FORM P0460

Pour tout renseignement concernant cette annexe : voir Journal Officiel de l'Office européen des brevets, No.12/82

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

### Littérature non-brevet citée dans la description

- SiC Trench MOSFET With Shielded Fin-Shaped Gate to Reduce Oxide Field and Switching Loss. *IEEE Electron Device Letters,* Octobre 2016, vol. 37 (10), 1324-1327
- The trench power MOSFET: Part I - History, technology, and prospects. *IEEE Transactions on Electron Devices,* Mars 2017, vol. 64 (3), 674-691